# EUROPÄISCHE PATENTSCHRIFT

(11) **EP 1 104 191 B1**
(45) Veröffentlichungstag und Bekanntmachung des Hinweises auf die Patenterteilung: **07.11.2012**
(21) Anmeldenummer: 00204062.4
(22) Anmeldetag: 17.11.2000
(51) Int. Cl.: H04N 7/035, H04L 7/00

(54) **Anordnung zur Feststellung der Phasenlage eines Datensignals**
Arrangement for determining the phase position of a data signal
Dispositif pour déterminer la position de phase d'un signal de données

(30) Priorität: 26.11.1999 DE 19956947
(43) Veröffentlichungstag der Anmeldung: 30.05.2001
(73) Patentinhaber: Trident Microsystems (Far East) Ltd., Grand Cayman (KY)
(72) Erfinder: Seeliger, Rolf, Philips Corporate Intellectual, 52064 Aachen (DE)
(74) Vertreter: Epping - Hermann - Fischer

(56) Entgegenhaltungen:
- EP-A- 0 472 756
- EP-A- 0 720 290

## Beschreibung

Die Erfindung betrifft eine Anordnung zur Feststellung der Phasenlage eines in Form digitaler Abtastwerte vorliegenden Datensignals mit asynchronen modulierten Daten, deren Modulationsfrequenz bekannt ist.

Ein Datensignal, dessen Bits bzw. Daten asynchron moduliert sind, deren Modulationsfrequenz aber bekannt ist, kann gegebenenfalls verschiedene Phasenlagen haben die festzustellen sind. Das Datensignal liegt in Form digitaler Abtastwerte vor. Insbesondere wenn die Abtastfrequenz, mit der die digitalen Abtastwerte gewonnen wurden, nicht mit der Modulationsfrequenz der Daten verkoppelt ist, ist nicht bekannt, welcher Abtastwert welches Bit repräsentiert und wo dieser Abtastwert innerhalb des Verlaufs dieses Bits liegt. Damit treten bei der Dekodierung der Bits erhebliche Probleme auf bzw. die Dekodierung ist störanfällig, beispielsweise rauschanfällig.

Zur Lösung dieses Problems ist aus der EP-A-O 472 756 eine Signal-Abtrennvorrichtung bekannt, welche dazu eingesetzt wird, ein Teletextsignal aus einem Videosignal abzutrennen. Die Schaltung arbeitet sehr aufwendig und weist eine Integriereinrichtung auf, die ein die Signalmittel der einzelnen Bits des Datensignals kennzeichnendes Halbstandsignal und ein Restwertsignal abgibt. Eine Restwertsignalbewertungseinrichtung wertet den jeweiligen Restwert aus und bestimmt mittels eines Auswahlsteuersignals wie der Wert des aktuellen Signalbits geschätzt werden soll. Dazu steht eine Auswahleinrichtung zur Verfügung, die aus dem jeweiligen aktuellen Abtastwert und dem jeweiligen vorhergehenden bzw. nachfolgenden Abtastwert den jeweiligen Vorlaufmittelwert bzw. Nachlaufmittelwert bildet und mittels des Auswahlsteuersignals den für die Schätzung geeigneten Wert auswählt. Eine weiter vorgesehene Phasenkorrektureinrichtung wertet ein von einer Flankenlogikeinrichtung geliefertes Signalmuster aus, das anzeigt, ob sich der aktuelle Abtastwert einer Flanke eines Signal nähert. Die gleiche Einrichtung steuert dann eine Änderung der Integrationsperiode, wenn das Restwertsignal innerhalb eines vorbestimmten Restwert signalbereiches liegt. Diese Anordnung arbeitet sehr aufwendig und kann dennoch nur eine Art Abschätzung der Lage der einzelnen Bits vornehmen.

Es ist Aufgabe der Erfindung, eine Anordnung der eingangs genannten Art anzugeben, die in der Lage ist, die Phasenlage der einzelnen Bits festzustellen, die die oben genannten Probleme löst, möglichst einfach aufgebaut ist und die gegebenenfalls, wenigstens teilweise, auch softwaremäßig realisierbar ist.

Diese Aufgabe ist erfindungsgemäß dadurch gelöst, dass die Anordnung Mittel aufweist, welche ein erstes und/oder ein zweites Verfahren zur Ermittlung der Bitpositionen des abgetasteten Datensignals durchführen,
dass die Anordnung Mittel (3,4) aufweist, welche ein erstes und/oder ein zweites Verfahren zur Ermittlung der Bitpositionen des abgetasteten Datensignals durchführen,
dass die Mittel in dem ersten Verfahren wenigsten einen Satz von jeweils drei oder fünf aufeinanderfolgenden Abtastwerten suchen, deren mittlerer Abtastwert größer oder kleiner als die ihm benachbarten äußeren Abtastwerte des Satzes ist und bei denen die Differenz(en) derjenigen äußeren Abtastwerte, die jeweils gleichen Abstand zum mittleren Abtastwert haben, einen vorgegebenen Schwellwert unterschreiten, wobei die Mittel bei Auffindung eines solchen Datensatzes die Position des mittleren Abtastwertes und eine zugeordnete, die Position des Bits in dem Datensignal angebende Positionszahl in einem Speicher (9) speichern,
dass die Mittel in dem zweiten Verfahren einen Satz von vier aufeinanderfolgenden Abtastwerten suchen, deren beide mittlere Abtastwerte näherungsweise gleich groß und deren mittlere Größe kleiner oder größer als die mittlere Größe der beiden äußeren Abtastwerte ist und bei denen die Differenz der äußeren Abtastwerte einen vorgegebenen Schwellwert unterschreitet, wobei die Mittel bei Auffindung eines solchen Datensatzes die Bitposition in der Mitte zwischen den beiden mittleren Abtastwerten und eine zugeordnete Positionszahl in einem Speicher (10) speichern,
und dass die Anordnung Mittel aufweist, welche aus wenigstens zwei ermittelten Bitpositionen, den diesen zugeordneten Positionszahlen und der Periodenlänge der Bits des Datensignals ein Phasensignal bestimmen, welches die Phasenlage der Bits des abgetasteten Datensignals relativ zu einem vorgebbaren Startpunkt liefert.

Es geht bei der Erfindung darum, die Phasenlage der einzelnen Bits der asynchronen modulierten Daten festzustellen und einem gegebenenfalls nachgeschalteten Dekoder, der nicht Bestandteil der Erfindung ist und der die Daten ermittelt, ein Phasensignal zu liefern, das dem Dekoder die Phasenlage der asynchronen modulierten Daten in dem Datensignal angibt.

Dieses Problem wird gegebenenfalls noch dadurch verschärft, dass bei nicht fester Verkopplung der Abtastfrequenz, mit der die digitalen Abtastwerte des Datensignals erzeugt wurden, und der Modulationsfrequenz, mit der die Daten in dem Datensignal moduliert wurden, die Phasenlage nicht fest bzw. nicht bekannt ist. Es findet dann ein Driften zwischen den einzelnen Abtastwerten und der Lage der Bits in dem Datensignal statt. Somit ist nicht bekannt, welcher Abtastwert welches Datenbit repräsentiert bzw. wo dieser Abtastwert innerhalb des Signalverlaufs dieses Bits liegt.

Genau dieses Problem soll die Erfindung lösen und ein Phasensignal liefern, das einem nachgeschalteten Dekoder angibt, welche Phasenlage die modulierten Bits des Datensignals relativ zu einem vorgebbaren Startpunkt aufweisen.

Um ein derartiges Phasensignal liefern zu können, muß die erfindungsgemäße Anordnung in der Lage sein festzustellen, welche genaue Position die Bits des Datensignals aufweisen. Hierfür sind in der Anordnung Mittel vorgesehen, welche ein erstes und/oder ein zweites Verfahren durchführen, bei denen die Bitpositionen des abgetasteten Datensignals ermittelt werden. Es werden hierbei, beispielsweise in einem vorgebbaren Zeit- oder Datenabschnitt des Datensignals, bestimmte Bitpositionen herausgesucht, die eine markante Lage relativ zu den Abtastwerten haben, so dass aus den Abtastwerten relativ präzise auf die Position der Bits geschlossen werden kann.

Diese Mittel suchen bei dem ersten Verfahren einen Satz von jeweils drei oder fünf aufeinanderfolgenden Abtastwerten, für die folgende Bedingungen gelten:

Der mittlere Abtastwert dieser drei oder fünf oder mehr Abtastwerte muß größer oder kleiner als sämtliche ihn benachbarten äußeren Abtastwerte sein, also als die übrigen zwei oder vier Abtastwerte dieses Satzes von Abtastwerten. Ferner muß die Differenz der äußeren Abtastwerte, die jeweils gleichen Abstand zum mittleren Abstandswert haben, minimal sein. Werden also drei Abtastwerte in einem Satz für dieses Verfahren herangezogen, so muß die Differenz dieser beiden Werte minimal sein. Werden fünf Abtastwerte in einem Satz für die Durchführung dieses Verfahrens herangezogen, so muß die Differenz zwischen dem ersten und dem letzten Abtastwert dieses Satzes von Abtastwerten minimal sein und ferner die Differenz zwischen dem zweiten und dem vierten Abtastwert dieses Satzes ebenfalls minimal sein.

Wird ein Satz von aufeinanderfolgenden Abtastwerten gefunden, für den diese Bedingungen erfüllt sind, so kann davon ausgegangen werden, dass der mittlere Abtastwert dieses Satzes von Abtastwerten recht genau ein Maximum oder ein Minimum in dem Signalverlauf des Datensignals repräsentiert. Damit repräsentiert dieser Abtastwert ziemlich genau eine zentrale Position eines Bits in dem Datensignal. Da genau dieses gesucht wird, wird bei Auffindung eines solchen Datensatzes, für den die oben beschriebenen Bedingungen erfüllt sind, die Position des mittleren Abtastwertes in einem Speicher abgespeichert. Ferner wird abgespeichert, welche Position dieses Bit in dem Datensignal hat, also beispielsweise um das wievielte Bit ab einem vorgebbaren Startpunkt es sich handelt. Auch dieser Wert wird als Positionszahl in dem Speicher abgespeichert.

Somit werden nach Durchführung des ersten Verfahrens beispielsweise für eine bestimmte Zeitdauer oder einen bestimmten Abschnitt des Datensignals mehrere Bitpositionen gefunden, für die die oben beschriebenen Bedingungen erfüllt sind und die dann in dem Speicher mit ihrer Positionszahl abgespeichert werden.

Zusätzlich oder auch alternativ zu dem ersten Verfahren führen die Mittel ein zweites Verfahren durch, bei dem ein Satz von vier aufeinanderfolgenden Abtastwerten gesucht wird, bei dem die Differenz der beiden mittleren Abtastwerte einen vorgegebenen Schwellwert unterschreitet und bei denen diese beiden Abtastwerte beide kleiner oder beide größer sind als die beiden äußeren Abtastwerte dieses Satzes. Ferner muß die Differenz der äußeren Abtastwerte gegebenenfalls einen vorgegebenen Schwellwert unterschreiten. Wird ein solcher Datensatz gefunden, so kann daraus geschlossen werden, dass das Zentrum des Bits, zu dem dieser Datensatz gehört, ziemlich genau eine Position zwischen den Positionen der beiden mittleren Abtastwerte aufweist. Somit wird eine Bitposition in der Mitte zwischen diesen beiden Abtastwerten und wiederum die zugeordnete Positonszahl, die die Position des Bits in dem Datensignal angibt, in einem Speicher abgespeichert. Auch hier gilt, dass im Verlaufe der Durchführung des Verfahrens mehrere solcher Datensätze gefunden werden, die die angegebenen Bedingungen erfüllen.

Die Anordnung bestimmt nun aus den abgespeicherten Bitpositionen und Positionszahlen das Phasensignal. Dies ist möglich, da die Länge der Bits, also deren Periodenlänge, infolge der bekannten Modulationsfrequenz ebenfalls bekannt ist. Es werden wenigstens zwei der abgespeicherten ermittelten Bitpositionen herangezogen, wobei bekannt ist, welche Positionen dieses Bits haben und um das wievielte Bit es sich jeweils handelt. Es ist also beispielweise für zwei abgespeicherte Bitpositionen bekannt, um wie viele Bits diese Positionen auseinander liegen und welche Positionen die Zentren der Bits haben. Aus diesen beiden bekannten Werten kann also bei bekanntem Abstand der Zentren der Bits, bei bekannten Positionen der Zentren der Bits und bei bekannter Periodenlänge unmittelbar die Phasenlage bestimmt werden. Mittels einer Bewertung der Güte der einzelnen Messpunkte kann die Exaktheit der zu ermittelnden Phasenlage erhöht werden. Die Anordnung ist somit in der Lage, die Phasenlage des Datensignals bzw. die Phasenlage der Bits dieses abgetasteten Datensignals relativ zu einem vorgebbaren Startpunkt anzugeben.

Es ist somit für einen nachgeschalteten Dekoder, der nicht Bestandteil der Erfindung ist, einfach möglich, die Bits zu dekodieren, da dem nachgeschalteten Dekoder anhand des Phasensignals genau bekannt ist, welche Positionen die Zentren der Bits des Datensignals haben. Somit ist der Dekoder unmittelbar in der Lage festzustellen, welche Abtastwerte welche Positionen relativ zu diesen Zentren der Bits haben und kann somit eine optimale Dekodierung vornehmen.

Für die Ermittlung des Phasensignals sind wenigstens zwei der ermittelten Bitpositionen heranzuziehen, die Genauigkeit des Verfahrens kann gegebenenfalls noch dadurch erhöht werden, dass mehr als zwei der gefundenen Bitpositionen zur Ermittlung des Phasensignals herangezogen werden.

Die Anordnung arbeitet recht einfach, da für die Durchführung der Verfahren immer nur Differenzen zu bilden sind und weitere Abschätzungen entfallen. Durch relativ einfache Berechnungen können die Bitpositionen und auch das Phasensignal bestimmt werden. Die Funktionen, die die Anordnung durchführt, sind ganz oder teilweise auch softwaremäßig realisierbar.

Eine nach Anspruch 2 vorgesehene Ausgestaltung der Erfindung sieht vor, dass die beiden Verfahren zur Ermittlung der Positionen der Bits des Datensignals auf in dem Datensignal vorgesehene Synchronisierbits angewendet werden, die beispielsweise jeweils einem Rahmen der Datenbits vorangestellt werden. Aus diesen Synchronisierbits kann dann das Phasensignal gewonnen werden, welches für nach den Synchronisierbits in dem Datensignal übertragenen Datenbits angewendet werden kann. Damit ist nach Übertragung der Synchronisierbits die Phasenlage des Datensignals für den nachfolgenden Datenblock bekannt und es kann einem gegebenenfalls nachgeschalteten Dekoder ein optimales Phasensignal für die Dekodierung der Datenbits zur Verfügung gestellt werden.

Bei einer weiteren Ausgestaltung der Erfindung nach Anspruch 3 wird für einen minimierten Aufwand für die Generierung des Phasensignals nur jeweils eine der gefundenen und abgespeicherten Bitpositionen gemäß dem ersten und dem zweiten Verfahren eingesetzt. Ergeben sich aus den abgespeicherten Bitpositionen eventuell leicht unterschiedliche Phasenlagen, so wird zwischen diesen ein Mittelwert gebildet und als Phasensignal ausgegeben. Damit ist bei minimiertem Aufwand dennoch ein recht präzises Phasensignal erzeugbar.

Werden in den beiden Verfahren jeweils mehrere Bitpositionen zugeordnete Positionszahlen bestimmt und in dem Speicher abgespeichert, so kann nach einer weiteren Ausgestaltung der Erfindung nach Anspruch 5 aus diesen vorteilhaft eine qualitative Auswahl getroffen werden. Dies kann vorteilhaft in der Weise geschehen, dass diejenigen Sätze von Abtastwerten herangezogen werden, für die die Differenzen nicht nur die vorgegebenen Schwellwerte unterschreiten, sondern minimal sind. Das heißt es werden diejenigen Datensätze herangezogen, deren oben beschriebene Differenzen am geringsten sind. Damit sind mit hoher Wahrscheinlichkeit diejenigen Datensätze gefunden worden, die am besten die genaue zentrale Position der jeweiligen Bits des Datensignals angeben.

Wie oben beschrieben, kann die Anordnung aus den abgespeicherten Bitpositionen, den zugeordneten Positionszahlen und der bekannten Modulationsfrequenz das Phasensignal berechnen. Umgekehrt kann jedoch auch, wie gemäß einer weiteren Ausgestaltung der Erfindung nach Anspruch 6 vorgesehen ist, aus den Abständen der ermittelten Bitpositionen und den zugeordneten Positionszahlen eine Bestimmung der Modulationsfrequenz des Datensignals vorgenommen werden. Diese Information kann beispielsweise dazu genutzt werden, eine Identifikation des Datensignals vorzunehmen, also zu überprüfen, ob die Modulationsfrequenz der erwarteten Modulationsfrequenz entspricht oder mittels der Modulationsfrequenz festzustellen, um welche Art von Datensignal es sich handelt. Diese Information kann beispielsweise dann, wenn es sich bei dem Datensignal um ein Teletext-signal eines Videosignals handelt, dazu eingesetzt werden, festzustellen, welche Übertragungsnorm das Teletextsignal aufweist.

Nach einer weiteren Ausgestaltung der Erfindung kann, wie gemäß Anspruch 7 vorgesehen ist, in der Anordnung vorteilhaft ein Fehlersignal ausgelöst werden, wenn innerhalb einer vorgegebenen Zeitspanne nicht wenigstens eine vorgegebene Anzahl von Bitzahlen ermittelt wird. Es kann dann davon ausgegangen werden, dass es sich entweder nicht um das erwartete Datensignal oder um ein gestörtes Datensignal handelt.

Die Anordnung kann vorteilhaft, wie gemäß einer weiteren Ausgestaltung nach Anspruch 8 vorgesehen ist, dazu eingesetzt werden, die Phasenlage von Teletextsignalen innerhalb eines Fernsehsignals festzustellen. Die Position der Teletextbits innerhalb einer Bildzeile des Fernsehsignals kann schwanken. Um dennoch einem nachgeschalteten Dekoder eine sichere Dekodierung zu ermöglichen, kann vorteilhaft die erfindungsgemäße Anordnung für jede Bildzeile ein Phasensignal liefern.

Wie gemäß einer weiteren Ausgestaltung der Erfindung nach Anspruch 10 vorgesehen ist, kann der dort vorgesehene Flankendetektor dazu eingesetzt werden, nur solche Abtastwerte in die oben beschriebenen Verfahren einzubeziehen, die zu Impulsen gehören, die wenigstens eine vorgegebene Flankenhöhe aufweisen. Damit kann erreicht werden, dass einzelne Störpeaks innerhalb des Datensignals nicht als Bitposition erkannt werden. Ferner wird nach diesem Anspruch mittels des Ausgangssignals des Flankendetektors ein nachgeschalteter Bitzähler angesteuert, der unmittelbar die Positionszahlen der einzelnen Bits liefert und dessen Wert bei der Durchführung der Verfahren unmittelbar als abzuspeichernde Positionszahl herangezogen werden kann.

Nachfolgend wird ein Ausführungsbeispiel der Erfindung anhand der Zeichnung näher erläutert. Es zeigen:
Fig. 1 zwei über der Zeit aufgetragene Schwingungszüge eines asynchronen modulierten Datensignals, wobei anhand der beiden Schwingungszüge die beiden Verfahren, die die Mittel in der Anordnung durchführen, erläutert werden und
Fig. 2 ein Blockschaltbild einer erfindungsgemäßen Anordnung zur Generierung eines Phasensignals.

Für das nachfolgend zu erläuternde Ausführungsbeispiel wird davon ausgegangen, dass es sich bei dem asynchronen modulierten Datensignal um ein abgetastetes Teletextsignal handelt. Das Teletextsignal wird innerhalb eines Fernsehsignals zeilenweise übertragen. Dabei wird in jeder Bildzeile des Fernsehsignals, in der Bits des Teletextsignals übertragen werden, zunächst einige Synchronisierbits übertragen, anhand der die erfindungsgemäße Anordnung das Phasensignal liefert, welches nachfolgend für Postionsbestimmungen von in dem Teletextsignal innerhalb jeder Bildzeile nachfolgend übertragenen Datenbits eingesetzt wird. Dieses Phasensignal kann in einem nachgeschalteten Dekoder, der nicht Bestandteil der Erfindung ist, vorteilhaft zur Dekodierung der Bits eingesetzt werden, da aufgrund dieses Phasensignals die genaue Lage der Bits relativ zu den Abtastwerten bekannt ist. Die Vorgehensweise der Dekodierung ist jedoch nicht Gegenstand der Erfindung, deren Aufgabe darin besteht, ein Phasensignal zu liefern, das eine optimale Dekodierung ermöglicht.

Für die Dekodierung eines solchen Teletextsignals liefert die erfindungsgemäße Anordnung einzeln für jede Bitzeile ein Phasensignal, das für die jeweilige Bitzeile die Phasenlage der Teletextbits relativ zu einem vorgebbaren Startpunkt angibt. Dies ist erforderlich, da die Positionen der Bits bzw. die Phasenlage des Teletextsignals von Bildzeile zu Bildzeile schwanken kann.

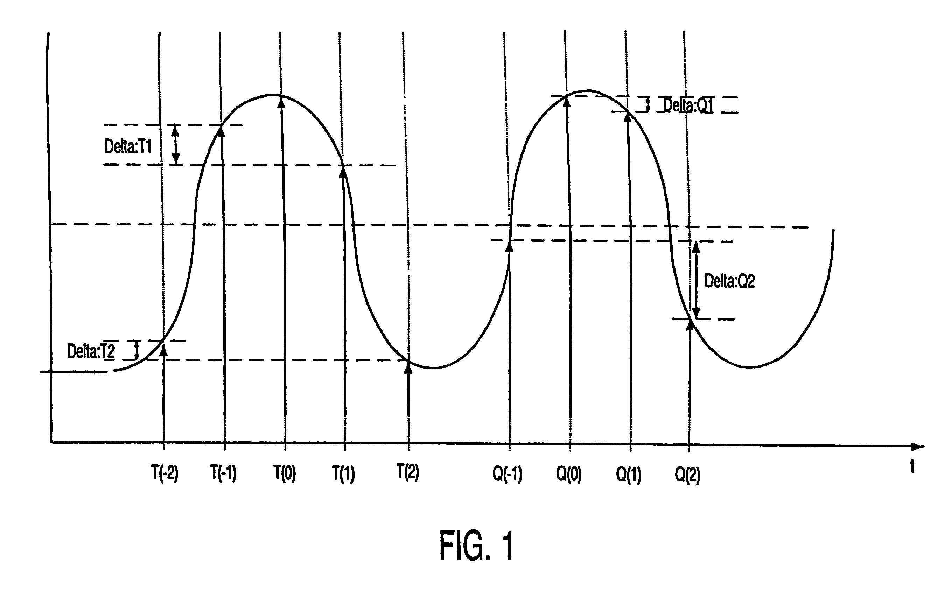

In Fig. 1 sind die Schwingungszüge zweier Synchronisierbits und deren Abtastwerte und-Positionen eines solchen analogen Teletextsignals, wie es beispielsweise in einem Fernsehsignal enthalten sein kann, über der Zeit aufgetragen.

In der Fig. 1 sind ferner Abtastwerte dieses Signals mit Pfeilen gekennzeichnet. Die Darstellung zeigt, dass aufgrund der nicht verkoppelten Abtastfrequenz, mit der die Abtastwerte erzeugt werden, diese sich gegenüber den Bitpositionen der Synchronisierbits beliebig verschieben können und aufgrund der gegebenenfalls nicht verkoppelten Frequenzen auch driften können.

Das Beispiel in Fig. 1 wird zur Erläuterung der beiden Verfahren herangezogen, wobei anhand des ersten in Fig. 1 dargestellten Bits das erste Verfahren und anhand des zweiten in der Fig. 1 dargestellten Bits das zweite Verfahren nachfolgend erläutert wird.

Bei dem ersten Verfahren wird ein Satz von Abtastwerten gesucht, für den zwei Bedingungen erfüllt sein müssen. Es muß der mittlere Abtastwert einen größeren oder kleineren Wert aufweisen, als zwei oder vier ihm benachbarte Abtastwerte. Ferner müssen die Differenzen der benachbarten Abtastwerte minimal sein, wobei jeweils die Differenz zwischen Abtastwerten berechnet wird, die jeweils gleiche Positionen relativ zu dem mittleren Abtastwert haben. Diese Differenzen müssen jeweils einen vorgegebenen Schwellwert unterschreiten. Ist dies der Fall, wird die ermittelte Bitposition, die der Position des mittleren Abtastwertes dieses Datensatzes entspricht, abgespeichert. Ferner wird die zugehörige Positionszahl abgespeichert, die die Lage des Bits in dem Datensignal angibt.

In dem Beispiel gemäß Fig. 1 ist ein mittlerer Abtastwert T(0) eingetragen, dessen Wert größer ist als die Werte der ihn unmittelbar umgebenden Abtastwerte T(-1) und T(1).

Er ist ferner größer als die jeweils zweiten Nachbarn T(-2) und T(2).

Für die Durchführung des ersten Verfahrens kann je nach gewünschter Genauigkeit und je nach Rechenaufwand entweder ein Satz von drei Abtastwerten oder ein Satz von fünf Abtastwerten herangezogen werden.

Es muß ferner die Bedingung erfüllt sein, dass die Differenz der benachbarten Abtastwerte T(-1) und T(1) einen vorgegebenen Schwellwert unterschreitet. Diese Differenz ist in der Figur mit Delta T1 gekennzeichnet.

Wird das Verfahren anhand von Sätzen mit fünf Abtastwerten vorgenommen, so ist außerdem die Differenz zwischen den Abtastwerten T(-2) und T(2), die in der Figur mit Delta T2 gekennzeichnet ist, heranzuziehen. Diese Differenz der Delta T2 muß ebenfalls einen vorgegebenen Schwellwert unterschreiten.

Wird in dem Beispiel gemäß Fig. 1 angenommen, dass sowohl die Differenz Delta T1 wie auch die Differenz Delta T2 den jeweils zugeordneten Schwellwert unterschreitet, so erfüllt der Satz der Abtastwerte T(0), T(-1), T(1), T(-2), und T(2) die oben angegebenen Bedingungen. Es ist damit eine zentrale Position eines Bits gefunden worden. Diese zentrale Position wird durch die Lage des Abtastwertes T(0) gekennzeichnet. Dessen Position wird als Bitposition in einem Speicher abgelegt. Ferner wird eine Positionszahl abgespeichert, welche angibt, um das wievielte Bit es sich handelt. Diese Positionszahl kann beispielsweise durch einen Flankendetektor ermittelt werden. Die Positionszahl kann aber auch anhand eines der beiden Verfahren gewonnen werden, da mittels der Verfahren die Positionen der einzelnen Bits festgestellt werden. Auch wenn Bitpositionen die Bedingungen der beiden Verfahren nicht erfüllen, so ergibt sich dennoch eine Möglichkeit, die Bits zu zählen. Aus diesen Informationen kann die Positionszahl bestimmt werden und zusammen mit der Bitposition des Abtastwertes T(0) in einem Speicher abgelegt werden.

Anhand des zweiten Schwingungszuges der Darstellung gemäß Fig. 1 soll nachfolgend die Durchführung des zweiten Verfahrens erläutert werden.

Die Bedingungen des zweiten Verfahrens sind, dass die Werte der beiden mittleren Abtastwerte, in dem Beispiel der Fig. 1 die Werte Q(0) und Q(1) größere oder kleinere Werte aufweisen als die sie benachbarten Abtastwerte, in dem Beispiel die Abtastwerte Q(-1) und Q(2).

Diese Bedingung ist in dem Beispiel gemäß Fig. 1 für den zweiten Schwingungszug erfüllt.

Ferner müssen die Differenzen zwischen den beiden mittleren Abtastwerten Q(0) und Q(1) und den äußeren Abtastwerten Q(-1) und Q(2) vorgegebene Schwellwerte unterschreiten. In der Fig. 1 sind diese Differenzen mit Delta Q1 und Delta Q2 gekennzeichnet. Unterschreiten diese beiden Differenzen die vorgegebenen Schwellwerte, so ist mittels des zweiten Verfahrens eine Bitposition gefunden worden, welche etwa eine mittlere Position zwischen den beiden Abtastwerten Q(0) und Q(1) hat. Diese Position wird als Bitposition zusammen mit der Positionszahl abgespeichert.

Anhand der abgespeicherten Bitpositionen und der jeweils zugeordneten Positionszahlen kann bei bekannter Modulationsfrequenz des Datensignals und somit bekannter Periodenlänge der Bits des Datensignals unmittelbar ein Phasensignal berechnet werden, welches die Phasenlage der Bits des Datensignals relativ zu einem vorgebbaren Startpunkt angibt.

Für die Ermittlung des Phasensignals können die mittels des ersten und/oder des zweiten Verfahrens ermittelten Bitpositionen und zugeordneten Positionszahlen herangezogen werden. Im einfachsten Falle wird je Verfahren eine Bitposition ermittelt und zur Bestimmung des Phasensignals herangezogen. Es können auch je Verfahren mehrere Bitpositionen ermittelt werden, aus denen diejenigen ausgewählt werden, für die die oben beschriebenen Differenzen minimal sind. Gegebenenfalls können die anhand der einzelnen Bitpositionen zu ermittelnden Phasenlagen geringfügig voneinander abweichen. In diesem Falle kann vorteilhaft ein Mittelwert aus den Phasenlagen gezogen werden und als Phasensignal ausgegeben werden.

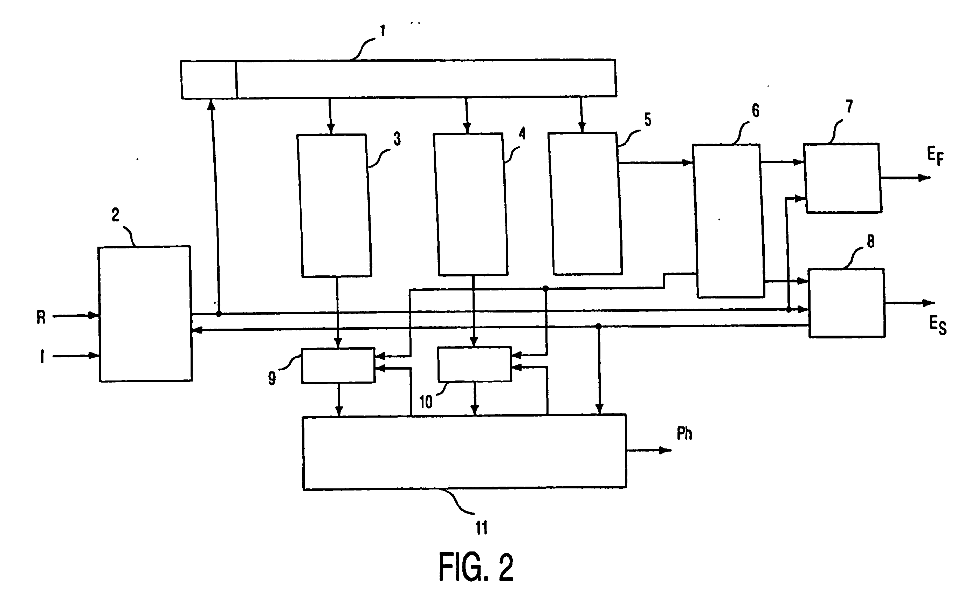

Ein in Fig. 2 dargestelltes Blockschaltbild zeigt eine erfindungsgemäße Anordnung zur Ermittlung der Phasenlage eines Datensignals. Bei dem Datensignal kann es sich beispielsweise um ein Teletextsignal handeln. Das Teletextsignal ist mit einer Abtastfrequenz, die nicht mit der Modulationsfrequenz der Bits des Teletextsignals verkoppelt ist, abgetastet. Die entsprechenden Abtastwerte werden in der Anordnung gemäß Fig. 1 in einen Pufferspeicher 1 abgespeichert. Dies kann beispielsweise für alle Abtastwerte einer Bildzeile des Fernsehsignals geschehen.

Innerhalb der Anordnung ist ein Adreßzähler 2 vorgesehen, dem einerseits ein Rücksetzsignal R zugeführt wird, das beispielsweise mit dem Beginn jeder neuen Bildzeile ausgelesen wird, so dass der Restzähler neu anfängt zu zählen. Ferner wird dem Adreßzähler 2 ein Inkrementsignal zugeführt, so dass der Adreßzähler 2 mit diesem Inkrementsignal hoch zählt, so dass in dem Pufferspeicher 1 die einzelnen Abtastwerte beispielsweise einer Bildzeile nach und nach adressiert werden.

Die so nach und nach adressierten Bits werden Mitteln 3 zur Durchführung des ersten Verfahrens und Mitteln 4 zur Durchführung des zweiten Verfahrens zugeführt.

Die Mittel 3 und 4 bestimmen in oben beschriebener Weise Datensätze, für die die jeweiligen Bedingungen der beiden Verfahren erfüllt sind. Die dabei ermittelten Bitpositionen werden in einem ersten Speicher 9 und in einem zweiten Speicher 10 abgespeichert.

Es ist ferner ein Flankendetektor 5 vorgesehen, welcher anhand der nach und nach adressierten Abtastwerte die einzelnen Bits identifiziert. Dies geschieht in der Weise, dass nur solche Bits berücksichtigt werden, welche nach Maßgabe der Abtastwerte wenigstens eine vorgegebene Flankenhöhe aufweisen. Der nachgeschaltete Bitzähler 6 zählt diese Bits.

Ist mittels der Mittel 3 oder 4 bei der Durchführung der beiden Verfahren eine Bitposition ermittelt worden, so wird zusammen mit dieser Bitposition die jeweilige Bitzahl bzw. Positionszahl, die der Zähler 6 liefert, ebenfalls in dem Speicher 9 bzw. Speicher 10 abgespeichert. Somit wird also in dem Speicher 9 bzw. 10 zu jeder dort abgespeicherten Bitposition die zugeordnete Positionszahl, die der Zähler 6 liefert, abgespeichert.

Innerhalb der Gesamtanordnung ist ferner eine Einheit 11 zur Bestimmung des Phasensignals vorgesehen. Diese Einheit 11 kann auf die in den Speicher 9 bzw. 10 abgespeicherten Bitpositionen und zugeordneten Positionszahlen zugreifen und diese auslesen. Anhand der abgespeicherten Bitpositionen und Positionszahlen bestimmt die Einheit 11 ein Phasensignal Ph, das sie für gegebenenfalls nachgeschaltete Dekoder, die nicht Bestandteil der Erfindung sind, zur Verfügung stellt.

Sowohl bei der Durchführung der beiden Verfahren mittels der Mittel 3 und 4 wie auch bei der Auswertung mittels der Einheit 11 sind grundsätzlich verschiedene Vorgehensweisen möglich.

Es genügt an sich, grundsätzlich nur ein Verfahren einzusetzen. Es können also alternativ entweder nur die Mittel 3 oder die Mittel 4 vorhanden sein.

Ferner können zwar beide Mittel 3 und 4 vorgesehen sein, es kann jedoch aus den Bitpositionen in den Speicher 9 und 10 jeweils nur ein Wert der beiden Verfahren in der Einheit 11 zur Ermittlung des Phasensignals herangezogen werden.

Eine weitere Möglichkeit besteht darin, aus gegebenenfalls mehreren in dem Speicher 9 bzw. 10 jeweils abgespeicherten Bitpositionen diejenigen Bitpositionen zur Ermittlung des Phasensignals auszuwählen, für die die zu berechnenden Differenzen minimal sind. Es kann also eine qualitative Auswahl aus den Bitpositionen gezogen werden.

Ferner kann sich aus den abgespeicherten Bitpositionen und Positionszahlen eine leicht differierende Phasenlage ergeben. In diesem Falle wird aus den Phasenlagen ein Mittelwert gezogen und als Phasensignal Ph ausgegeben.

Im einfachsten Fall wird nur jeweils eine Bitposition samt zugeordneter Positionszahl aus dem Speicher 9 und 10 entnommen. Aus diesen beiden Bitpositionen kann die Phasenlage bestimmt werden und als Phasensignal Ph ausgegeben werden.

In der Anordnung sind ferner eine Einheit 7 zur Frequenzüberprüfung und eine Einheit 8 zur Fehlerprüfung vorgesehen. Diese beiden Einheiten sind grundsätzlich optional; sie können aber die Betriebssicherheit der Anordnung erhöhen.

Die Einheit 7 zur Frequenzprüfung liefert ein Fehlersignal E_{F}, welches dann erscheint, wenn die Modulationsfrequenz des Datensignals nicht in einem vorgegebenen Rahmen liegt. Dann kann darauf geschlossen werden, dass es sich nicht um das gewünschte Datensignal handelt. Diese Frequenz kann die Einheit 7 aus der Zahl der ermittelten Bits, die von dem Bitzähler 6 geliefert werden und der Zahl der Adressen, die von dem Adressenzähler 2 geliefert werden, bestimmen. Liegt dieser Frequenz nicht in einem vorgegebenen Rahmen, so wird das Frequenzfehlersignal E_{F} ausgegeben und die Anordnung stellt die Berechnung des Phasensignals Ph ein.

Die Einheit 8 zur Fehlerüberprüfung zählt diejenigen Bits, die innerhalb eines vorgegebenen Zeitrahmens erkannt werden. Der Zeitrahmen wird durch die Adreßdaten des Adreßzählers bestimmt und die Zahl der Bits ergibt sich aus dem Bitzähler 6. Wird innerhalb einer vorgegebenen Zeitspanne nicht eine Mindestzahl von Bits erkannt, wird ebenfalls die Bestimmung des Phasensignals Ph gestoppt. Dies geschieht, indem die Einheit 8 ein entsprechendes Fehlersignal sowohl an den Adreßzähler 2 wie auch an die Einheit 11 zur Bestimmung des Phasensignals liefert.

In der Darstellung gemäß Fig. 2 ist die Anordnung in Form eines Blockschaltbildes dargestellt, dessen Komponenten hardwaremäßig realisiert werden können. Es ist jedoch auch eine softwaremäßige Realisierung möglich, die gegebenenfalls auch nur einzelne Komponenten umfassen kann.

Insgesamt ist die erfindungsgemäße Anordnung relativ einfach aufgebaut. Insbesondere sind die vorzunehmenden Rechenprozesse sehr einfach, da es sich um einfache Differenzbildungen bzw. Zählprozesse handelt.

## Patentansprüche

1. Anordnung zur Feststellung der Phasenlage eines in Form digitaler Abtastwerte vorliegenden Datensignals mit asynchronen modulierten Daten, deren Modulationsfrequenz bekannt ist,
**dadurch gekennzeichnet,**
**dass** die Anordnung Mittel (3,4) aufweist, welche ein erstes und/oder ein zweites Verfahren zur Ermittlung der Bitpositionen des abgetasteten Datensignals durchführen,
**dass** die Mittel in dem ersten Verfahren wenigsten einen Satz von jeweils drei oder fünf aufeinanderfolgenden Abtastwerten suchen, deren mittlerer Abtastwert größer oder kleiner als die ihm benachbarten äußeren Abtastwerte des Satzes ist und bei denen die Differenz(en) derjenigen äußeren Abtastwerte, die jeweils gleichen Abstand zum mittleren Abtastwert haben, einen vorgegebenen Schwellwert unterschreiten, wobei die Mittel bei Auffindung eines solchen Datensatzes die Position des mittleren Abtastwertes und eine zugeordnete, die Position des Bits in dem Datensignal angebende Positionszahl in einem Speicher (9) speichern,
**dass** die Mittel in dem zweiten Verfahren einen Satz von vier aufeinanderfolgenden Abtastwerten suchen, deren beide mittlere Abtastwerte näherungsweise gleich groß und deren mittlere Größe kleiner oder größer als die mittlere Größe der beiden äußeren Abtastwerte ist und bei denen die Differenz der äußeren Abtastwerte einen vorgegebenen Schwellwert unterschreitet, wobei die Mittel bei Auffindung eines solchen Datensatzes die Bitposition in der Mitte zwischen den beiden mittleren Abtastwerten und eine zugeordnete Positionszahl in einem Speicher (10) speichern,
und **dass** die Anordnung Mittel aufweist, welche aus wenigstens zwei ermittelten Bitpositionen, den diesen zugeordneten Positionszahlen und der Periodenlänge der Bits des Datensignals ein Phasensignal bestimmen, welches die Phasenlage der Bits des abgetasteten Datensignals relativ zu einem vorgebbaren Startpunkt liefert.

2. Anordnung nach Anspruch 1,
**dadurch gekennzeichnet,**
**dass** die Mittel (3,4) die beiden Verfahren auf in dem Datensignal vorgesehene Synchronisierbits anwenden und das daraus bestimmte Phasensignal für die Ermittlung von Datenbits zur Verfügung stellen, die in dem Datensignal nach den Synchronisierbits übertragen werden.

3. Anordnung nach Anspruch 1,
**dadurch gekennzeichnet,**
**dass** die Mittel (3,4) mittels des ersten und des zweiten Verfahrens jeweils wenigstens einen Satz von Abtastwerten ermitteln, der die Bedingungen am ehesten erfüllt, und dass Mittel vorgesehen sind, welche für die Ermittlung des Phasensignals aus den mit den beiden Verfahren ermittelten Bitpositionen und den sich daraus ergebenden Phasenlagen ein Mittelwert wählen.

4. Anordnung nach Anspruch 1 oder 2,
**dadurch gekennzeichnet,**
**dass** Mittel (3,4) im ersten Verfahren jeweils aus drei Abtastwerten einen Satz von Abtastwerten bilden.

5. Anordnung nach Anspruch 1,
**dadurch gekennzeichnet,**
**dass** die Mittel (3,4) mittels der beiden Verfahren jeweils mehrere Bitpositionen und zugeordnete Positionszahlen bestimmen und aus diesen eine qualitative Auswahl in der Weise treffen, dass sie Bitpositionen aussuchen und zur Bestimmung des Phasensignals heranziehen, welche aus solchen Sätzen von Abtastwerten bestimmt wurden, für die die Differenz der äußeren Abtastwerte minimal ist.

6. Anordnung nach Anspruch 1,
dadurch gekennzeichenet,
dass Mittel vorgesehen sind, die aus den Abständen der ermittelten Bitpositionen zueinander und den zugeordneten Positionszahlen eine Bestimmung der Modulationsfrequenz des Datensignals vornehmen, welche zur Identifikation des Datensignals herangezogen wird.

7. Anordnung nach Anspruch 1,
**dadurch gekennzeichnet,**
**dass** die Anordnung Mittel aufweist, welche ein Fehlersignal auslösen, wenn sie innerhalb einer vorgegebenen Zeitspanne nicht wenigstens eine vorgegebene Anzahl von Bitzahlen ermitteln.

8. Anordnung nach Anspruch 1,
**dadurch gekennzeichnet,**
**dass** sich bei dem Datensignal um ein Teletext-Signal eines Fernsehsignals handelt, das mit einer Abtastfrequenz abgetastet wurde, die mit der Zeilenfrequenz des Fernsehsignals verkoppelt ist und die vorzugsweise etwa 13,5 MHz beträgt.

9. Anordnung nach Anspruch 1 oder 8,
**dadurch gekennzeichnet,**
**dass** die Abtastfrequenz nicht mit der Modulationsfrequenz verkoppelt ist.

10. Anordnung nach Anspruch 1,
**dadurch gekennzeichnet,**
**dass** in der Anordnung ein Flankendetektor (5) vorgesehen ist, dessen Ausgangssignal dazu herangezogen wird, in die Verfahren nur diejenigen Abtastwerte einzubeziehen, die zu Impulsen gehören, die wenigstens eine vorgegebene Flankenhöhe aufweisen, und dass mittels des Ausgangssignals des Flankendetektors und eines nachgeschalteten Bitzählers (6) die Positionszahlen bestimmt werden.

## Claims

1. An arrangement for determining the phase position of a data signal with asynchronous, modulated data whose modulation frequency is known,
**characterized in that**
the arrangement comprises means (3, 4) that carry out a first and/or a second method for determining the bit positions of the scanned data signal, that the means in the first method search for at least one set of three or five successive scanned values whose average scanned value is greater or smaller than the outer scanned values, which are adjacent to it, of the set and in which the difference(s) of those outer scanned values that have the same distance to the average scanned value drop(s) below a given threshold value, whereby the means store, upon the finding of such a data set, the position of the average scanned value and an associated position number indicating the position of the bits in the data signal in a memory (9),
that the means in the second method search for a set of four successive scanned values whose two average scanned values are approximately equally large and whose average magnitude is smaller than or greater than the average magnitude of the two outer scanned values and in which the difference of the outer scanned values drops below a given threshold value, whereby the means store, upon the finding of such a data set, the bit position in the middle between the two average scanned values and an associated position number in a memory (10),
and that the arrangement comprises means that determine from at least two determined bit positions the position numbers associated with the latter and determine from the period length of the bits of the data signal a phase signal that supplies the phase length of the bits of the scanned data signal relative to a settable starting point.

2. The arrangement according to claim 1,
**characterized in that**
the means (3, 4) use the two methods on synchronizing bits provided in the data signal and make available the resulting phase signal for determining data bits that are transmitted in the data signal to the synchronizing bits.

3. The arrangement according to claim 1,
**characterized in that**
the means (3, 4) determine at least one set of scanned values by the first and the second method which set best meets the conditions, and that means are provided that select an average value for the determining of the phase signal from the bit positions determined with the two methods and from the resulting phase positions.

4. The arrangement according to claim 1 or 2,
**characterized in that**
means (3, 4) form a set of scanned values in the first method from three scanned values.

5. The arrangement according to claim 1,
**characterized in that**
the means (3, 4) determine several bit positions and associated position numbers by the two methods and make a qualitative selection from them in such a manner that they search for bit positions and use them to determine the phase signal that was determined from such sets of scanned values for which the difference of the outer scanned values is minimal.

6. The arrangement according to claim 1,
**characterized in that**
means are provided that make a determination of the modulation frequency of the data signal from the distances of the determined bit positions to each other, which determination is used for the identification of the data signal.

7. The arrangement according to claim 1,
**characterized in that**
the arrangement comprises means that initiate an error signal if they do not determine at least one given number of bit numbers within a given time frame.

8. The arrangement according to claim 1,
**characterized in that**
the data signal concerns a teletext signal of a television signal that was scanned with a scanning frequency that is coupled to the line frequency of the television signal and that is approximately 13.5 MHz.

9. The arrangement according to claim 1 or 8,
**characterized in that**
the scanning frequency is not coupled to the modulation frequency.

10. The arrangement according to claim 1,
**characterized in that**
a flank detector (5) is provided in the arrangement whose output signal is used to include only those scanned values into the methods that belong to impulses that have at least one given flank height, and that the position numbers are determined by the output signal of the flank detector and by a bit counter (6) connected in downstream.

## Revendications

1. Agencement pour déterminer la position de phase d'un signal de données avec des données modulées asynchrones dont la fréquence de modulation est connue,
dans lequel
l'agencement comprend des moyens (3, 4) qui effectuent un première et/ou un deuxième méthode de détermination des positions des bits du signal de données balayées, les moyens dans la première méthode recherchent au moins un série de trois ou cinq valeurs balayées successives dont la valeur balayée moyenne est supérieure ou inférieure aux valeurs balayées extérieures, adjacentes à celle-ci, de la série et dans lequel la(les) différence(s) de ces valeurs balayées extérieures qui sont à la même distance de la valeur balayée moyenne baisse(nt) en dessous d'une valeur seuil donnée, de sorte que, à l'obtention d'une telle série de données, les moyens stockent dans une mémoire (9) la position de la valeur balayée moyenne et un numéro de position associé indiquant la position des bits dans le signal de données,
les moyens dans la deuxième méthode recherchent un série de quatre valeurs balayées successives dont les deux valeurs balayées moyennes ont à peu près la même grandeur et dont l'amplitude moyenne est inférieure ou supérieure à l'amplitude moyenne des deux valeurs balayées extérieures et dans lesquels la différence des valeurs balayées extérieures baisse au-dessous d'une valeur seuil donnée, de sorte que, à l'obtention d'un tel série de données, les moyens stockent dans une mémoire (10) la position des bits au milieu, entre les deux valeurs moyennes balayées et un nombre de position associé,
l'agencement comprend des moyens qui déterminent à partir d'au moins deux positions de bits prédéterminées les nombres de positions associés à ce dernier et déterminent à partir de la longueur de la période des bits un signal de phase qui fournit la longueur de phase des bits du signal de données balayées par rapport à un point de départ réglable.

2. Agencement selon la revendication 1,
dans lequel
les moyens (3, 4) utilisent les deux méthodes sur les bits de synchronisation fournis dans le signal de données et mettent à disposition le signal de phase qui en résulte pour déterminer les bits de données qui sont transmis dans le signal de données aux bits de synchronisation.

3. Agencement selon la revendication 1,
dans lequel
les moyens (3, 4) déterminent au moins une série de valeurs balayées par la première et la deuxième méthode qui correspond le mieux aux conditions, et des moyens qui sélectionnent une valeur moyenne pour déterminer le signal de phase à partir des positions de bits déterminées par les deux méthodes et à partir des positions de phase qui en résultent.

4. Agencement selon les revendications 1 ou 2,
dans lequel
les moyens (3, 4) forment un série de valeurs balayées dans la première méthode à partir de trois valeurs balayées.

5. Agencement selon la revendication 1,
dans lequel
les moyens (3, 4) déterminent plusieurs positions de bits et des nombres de positions associés par les deux méthodes et effectuent une sélection qualitative à partir de ceux-ci de telle manière qu'ils recherchent des positions de bits et les utilisent pour déterminer le signal de phase qui a été déterminé à partir de ces séries de valeurs balayées pour lesquelles la différence des valeurs balayées extérieures est minime.

6. Agencement selon la revendication 1,
dans lequel
des moyens sont prévus qui déterminent la fréquence de modulation du signal de données à partir des distances entre les positions de bits prédéterminées, détermination qui est utilisée pour identifier le signal de données.

7. Agencement selon la revendication 1,
dans lequel
l'agencement comprend des moyens qui déclenchent un signal d'erreur s'ils ne déterminent pas au moins un nombre donné de nombres de bits dans un laps de temps donné.

8. Agencement selon la revendication 1,
dans lequel
le signal de données se rapporte à un signal de télétexte d'un signal de télévision qui a été balayé avec une fréquence de balayage qui est couplée à la fréquence de ligne du signal de télévision et qui est d'environ 13,5 MHz.

9. Agencement selon les revendications 1 ou 8,
dans lequel
la fréquence de balayage n'est pas couplée à la fréquence de modulation.

10. Agencement selon la revendication 1,
dans lequel
un détecteur de flanc (5) est prévu dans l'agencement dont le signal de sortie est utilisé pour inclure uniquement les valeurs balayées dans les méthodes qui appartiennent à des impulsions ayant au moins une hauteur de flanc donnée, et les nombres de positions sont déterminés par le signal de sortie du détecteur de flanc et par un compteur de bits (6) connecté en aval.
